# EUROPEAN PATENT SPECIFICATION

(11) **EP 4 466 953 B1**
(45) Date of publication and mention of the grant of the patent: **29.10.2025**
(21) Application number: 23701275.2
(22) Date of filing: 17.01.2023
(51) Int. Cl.: H05G 2/00, C22C 24/00

(54) **TARGET MATERIAL, HIGH-BRIGHTNESS EUV SOURCE AND METHOD FOR GENERATING EUV RADIATION**
ZIELMATERIAL, EUV-QUELLE MIT HOHER HELLIGKEIT UND VERFAHREN ZUR ERZEUGUNG VON EUV-STRAHLUNG
MATÉRIAU CIBLE, SOURCE D'UVE À HAUTE LUMINOSITÉ ET PROCÉDÉ DE GÉNÉRATION DE RAYONNEMENT D'UVE

(30) Priority: 17.01.2022 RU 2022100914
(43) Date of publication of application: 27.11.2024
(73) Proprietor: ISTEQ B.V., 5656 AE Eindhoven (NL); ISTEQ Group Holding B.V., 5656 AE Eindhoven (NL)
(72) Inventor: ASTAKHOV, Dmitrii Igorevich, Troitsk, Moscow 108840 (RU); ELLWI, Samir, Crawley RH107UQ (GB); GLUSHKOV, Denis Aleksandrovich, 3434 KT Nieuwegein (NL); IVANOV, Vladimir Vitalievich, Moscow 119421 (RU); KHRISTOFOROV, Oleg Borisovich, Moscow 115551 (RU); KOSHELEV, Konstantin Nikolaevich, Moscow 108841 (RU); KRIVOKORYTOV, Mikhail Sergeyevich, Kirov 610027 (RU); KRIVTSUN, Vladimir Mikhailovich, Troitsk, Moscow 108840 (RU); LASH, Aleksandr Andreevich, Moscow 127051 (RU); MEDVEDEV, Vyacheslav Valerievich, Moscow 108840 (RU); VINOKHODOV, Aleksandr Yurievich, Troitsk, Moscow 108840 (RU)
(74) Representative: Knöner, Gregor
(86) International application number: PCT/EP2023/050981
(87) International publication number: WO 2023/135322

(56) References cited:
- EP-A1- 3 926 656
- DE-A1- 102013 220 189
- US-A1- 2005 167 617
- US-A1- 2007 196 256
- US-A1- 2019 319 259
- US-B2- 10 962 873
- PRUVOST S ET AL: "Co-intercalation into graphite of lithium and sodium with an alkaline earth metal", CARBON, ELSEVIER OXFORD, GB, vol. 42, no. 8-9, 1 January 2004 (2004-01-01), pages 1825 - 1831, XP004509642, ISSN: 0008-6223, DOI: 10.1016/J.CARBON.2004.03.014
- BRAGA M H ET AL: "Experimental and ab initio study of the Ag-Li system for energy storage and high-temperature solders", JOURNAL OF ALLOYS AND COMPOUNDS, ELSEVIER SEQUOIA, LAUSANNE, CH, vol. 817, 28 October 2019 (2019-10-28), XP086018597, ISSN: 0925-8388, [retrieved on 20191028], DOI: 10.1016/J.JALLCOM.2019.152811
- "Progress in LPP EUV Source Development at Osaka University", SPIE, PO BOX 10 BELLINGHAM WA 98227-0010 USA, 2006, XP040221147

## Description

### FIELD OF THE INVENTION

The invention relates to a Li-containing target material for use in a plasma source, as well as to high-brightness extreme ultraviolet (EUV) light sources and a method for generating EUV radiation, which may include mitigation of debris particles generated by a plasma along with radiation.

### BACKGROUND OF INVENTION

High-brightness EUV light sources are used in many fields: microscopy, materials science, biomedical and medical diagnostics, materials testing, crystal and nanostructure analysis, atomic physics, and lithography.

Synchrotrons can be used as such radiation sources, but they are extremely expensive and not available everywhere.

An alternative is sources in which plasma effectively emitting in the EUV (10-20 nm) range can be obtained both by focusing the radiation of high-power lasers on the target and in the discharge. The EUV light generation is most effective with the use of laser-produced plasma (LPP).

The development of EUV light sources, radiating at a spectral range (13.5±0.135 nm) corresponding to the reflection band of multilayer Mo/Si mirrors, in recent years has been largely stimulated by the development of projection EUV lithography for high-volume manufacturing of chips with 7 nm node and below.

For highly efficient generation of EUV radiation at 13.5 nm, it is known to use high-temperature plasma of a number of elements, in particular, xenon (Xe), lithium (Li), tin (Sn). Unlike other materials, the use of Li as a material of target makes it possible to obtain practically monochromatic radiation from a single resonant transition of hydrogen-like Li²⁺ at a wavelength of 13.5 nm. Measured linewidth of the Li²⁺ emission at 13.5 nm was limited by the spectral resolution of the spectrograph and was estimated to λ/Δλ≈1800, as it is known from the publication Schriever G, et al. Laser-produced lithium plasma as a narrow-band extended ultraviolet radiation source for photoelectron spectroscopy. Appl Opt. 1998 Mar 1; 37(7):1243-8.

Production of radiating lithium plasma is known using methods that include: discharge in metal vapors initiated by a laser, U.S. Patent 7427766, publ. 23.09.2008; production of laser plasma with droplet Li target, U.S. Patent 7449703, publ. 11.110.2008, and with jet Li target, U.S. Patent 9476841, publ. 25.10.201 6.

Thus, essentially, a point and monochromatic radiation source based on Li-plasma is attractive for numerous applications with the possibility of using various optical systems: based on multilayer Mo/Si mirrors having a high (70%) reflection coefficient at 13.5 nm, and/or based on Fresnel zone plates, etc. One of the advantages of using Li as a material of target is due to its relatively low melting point, 160.54°C.

However, during production of EUV radiation, debris particles are produced as a by-product, which can degrade the surface of optics integrated with the EUV light source. The debris, generated as a by-product of the plasma during the EUV light source operation, can be in the form of high-energy ions, neutral atoms and clusters or microdroplets of target material.

From the international patent application PCT/RU2012/000701, published under the number WO 2013/122505 A1, a short-wavelength radiation source based on laser-initiated discharge produced plasma in metal vapor is known. The electrodes can be in the form of liquid metal jets or in the form of rotating disks wetted with the molten target material. The laser beam is directed at the irradiation site of one of the electrodes in such a way that the discharge has a curved, banana-like shape. The intrinsic magnetic field of such a discharge has a gradient that determines the predominant movement of the discharge plasma flow into the region of a less strong magnetic field in a direction significantly different from the direction of the EUV beam output. The invention provides a simple and highly effective suppression of charged particles in the radiation beam.

However, suppression of the flow of neutral particles and microdroplets requires more sophisticated means for debris mitigation.

In patent applications PCT/RU 2018/000520 published on May 31, 2019 under the number WO 2019103648, PCT/EP2020/061562 published on October 29, 2020 under the number WO 2020216950 and patent RU2743572 published on February 20, 2021, a new approach has been proposed for the development of high-brightness LPP light sources based on a fast rotating, linear velocity of about 100 m/s, liquid metal target, which provides highly efficient debris mitigating by redirecting of the droplet fraction of debris particles away from the optical collector and the input window for the laser beam. This method for debris mitigation is highly effective when using target material with a sufficiently high density ρ, for example, tin with ρ= 7.31 g /cm³.

The document US 2005/167617 A1 describes the use of halogenides of Li for the generation of EUV radiation for lithographic projection. Lithium halogenides are employed, such as LiI (lithium-iodide), LiBr, or LiCl.

The document "Progress in LPP EUV Source Development at Osaka University", SPIE, PO BOX 10 BELLINGHAM WA 98227-0010 USA, 2006, discloses that Sn-based laser produced plasma (LLP) is favorable for EUV sources because of the high conversion efficiency of Sn.

The document US 10 962 873 B2 describes an EUV source that employs a target droplet generator that provides target droplets of Sn, Li or an alloy of Sn and Li.

The document EP 3926656 A1 describes an X-ray source with a rotating liquid metal target. The X-ray source uses Ga and Sn or an GaSn alloy as a preferred target and an electron gun interacts with the target material to generate X-ray radiation.

However, the use of Li as a target material is characterized by an excessively high rate of formation of the droplet fraction of debris particles due to the low density of the material of target (ρ=0.534 g/cm³), fragments of which, as a result of the impact of explosive-type shock pulses in the interaction zone, acquire speeds reaching 1000 m/s, which dramatically reduces the effectiveness of protection against the droplet fraction of Li-target debris.

### SUMMARY OF THE INVENTION

Accordingly, there is a need to eliminate the drawbacks mentioned above. In particular, there is a need for improved LPP EUV light sources with high spectral brightness at 13.5 nm using lithium as a plasma-forming target material. It would further be beneficial if the light source would be compact, powerful, and provide highly efficient, preferably an almost complete, debris mitigation.

This need is met by the features of the independent claims. The dependent claims describe embodiments of the invention.

According to the invention, there is provided a target material for use in a plasma source constructed and arranged to generate a radiation beam having a wavelength in an extreme ultraviolet (EUV) range, said target material comprising or consisting of a lithium (Li)-based composition with at least one further element, configured for multiple, more than three times, increasing the density of the target material compared to the density of Li. The type and amount of the at least one further element in the composition is configured such that the density of the target material is increased more than three times compared to the density of Li.

According to the invention, the further element is selected from the group consisting of Ag, Au, Bi, Ba, Sr.

In the preferred embodiment of the invention, the composition comprises an eutectic alloy. The atomic percentage (or amount-of-substance fraction) of Li in the target material may be in the range from 60% to 90% (which may also be written as at%).

In the preferred embodiment, the atomic percentage of the at least one further element in the target material may be in the range from 10% to 40%, for example from 15% to 30%. Preferably, the sum of the atomic percentage of Li and of the at least one further element in the target material amount to (about) 100%. The term 'about' may refer to a remainder of impurities and/or contaminants that may be present, for example in dependence on the purity of the source materials from which the target material is formed.

The invention relates to a plasma source of EUV radiation characterized in that the plasma is produced from the target material made in accordance with the present invention.

According to the invention, plasma is either a laser produced plasma (LPP) or a laser-initiated discharge produced plasma.

In the preferred embodiment of the invention, a speed of a droplet fraction of debris particles ejected from the plasma of the target material is many times, about an order of magnitude, less compared to the speed of the droplet fraction of debris particles ejected from plasma of a lithium target.

In the preferred embodiment of the invention, a target speed is greater or equal to the average speed of the droplet fraction of debris particles ejected from the plasma.

In another aspect, the invention relates to a method for generating EUV radiation comprising generating a radiation beam having a wavelength in an EUV range by means of a plasma source using a target material having any of the configurations described herein.

In an embodiment, the method may further comprise: forming under an action of a centrifugal force a target as a layer of molten target material on a surface of annular groove, implemented in a rotating target assembly with target surface facing a rotation axis; irradiating, preferably at a pulse repetition rate, e.g. a high pulse repetition rate such as higher than 10 kHz, the target by a focused laser beam; generating the laser produced plasma in an interaction zone and outputting an EUV radiation beam through the means for debris mitigation. Said molten target material comprises any of the target material disclosed herein, in particular a Li-based composition with at least one further element, configured for multiple, more than three times, increasing the density of the target material compared to the density of Li. The target is rotated at a high linear velocity of at least 100 m/s.

In a preferred embodiment of the invention, the centrifugal acceleration of the target is at least 10,000 g, where g is the acceleration of gravity.

In the embodiment of the invention, a spatial distribution of a debris ejection rate from the interaction zone is calculated and directions of a passage of both the focused laser beam and the EUV radiation beam are selected in spatial regions with minimal debris ejection rates.

In a preferred embodiment of the invention, the debris mitigation is provided by one or more debris mitigation techniques, comprising: protective gas flow, a magnetic mitigation, a foil trap, a debris shield, a membrane mostly transparent for EUV radiation, with a transparency of more than 60%.

In the preferred embodiment of the invention, in the EUV radiation beam, the spectral filtering of narrow-band radiation is provided at the transitions of ionized Li²⁺ with a wavelength of 13.5 nm.

In another aspect, the invention relates to an EUV radiation source comprising: a vacuum chamber, a rotating target assembly supplying a target into an interaction zone with a laser beam, preferably a pulsed laser beam, focused onto the target which is a layer of molten target material on a surface of an annular groove implemented in a rotating target assembly with a target surface facing an rotation axis, an EUV radiation beam exiting the interaction zone, and means for debris mitigation.

The EUV radiation source differs in that the target material is made in accordance with any of the embodiments of the present invention, and the linear velocity of the target is preferably at least 100 m/s. The EUV radiation source may use the plasma source in any of the configurations described herein.

In the preferred embodiment of the invention, a spectral purity filter is installed in the way of the EUV radiation beam.

The spectral purity filter is selected from the group comprising or consisting of: a reflective filter in the form of a multilayer Mo/Si mirror, foil containing zirconium or beryllium.

In the preferred embodiment of the invention, means of debris mitigation are provided by one or more debris mitigation techniques, comprising: protective gas flow, a magnetic mitigation, a foil trap, a debris shield, a membrane mostly transparent for EUV radiation.

The following causal relationships may exist between preferred features of the present invention and the achieved technical result.

According to an embodiment, the addition of a small amount of a further element to the Li-based target material (with Li density ρ=0.534 g/cm³), for example, 10% to 40%, e.g. about 20%, of the atomic fraction (or amount-of-substance fraction) of Ag (ρ=10.5 g/cm³) or Au (ρ=19.32 g/cm³) practically does not change the intensity of the 13.5nm emission line of lithium plasma.

At the same time, the density of the target material, which can be called "heavy lithium" increases many times: 4.7 or 8 times, respectively, compared with the density of Li, and the melting point remains relatively low: about 150 °C for an alloy with Ag and 280 °C for alloy with Au. In turn, a higher density of the target material leads to a multiple decrease in the velocity of the most problematic droplet fraction of debris particles, allowing to control the direction of its predominant ejection from the plasma when using a high target velocity (100 m/s or more).

The use of Ag and Au as the further element of the target material is preferable, since these materials are non-toxic, chemically non-aggressive and make it possible to obtain eutectic fusible alloys with a high (from 60 to 90%) proportion of Li content at a target density many times higher than the density of Li.

Additionally or alternatively, as a further element of the material of target, Bi (ρ=9.79 g/cm³), Ba (ρ=3.5 g/cm³), Sr (ρ=2.54 g/cm³) can be used.

The plasma emission band of the further component of the target material is separated from the 13.5nm emission line of doubly ionized lithium so that it can be easily cut off without the use of complex optical systems, for example, simply by reflection from a Mo/Si mirror, ensuring, in essence, the monochromaticity of the EUV source. Monochromaticity of the EUV source makes it possible to use a wide range of optical elements with it, which include multilayer Mo/Si mirrors, grazing-incidence mirrors, Fresnel zone plates, and expands the range of applications of essentially point (with a characteristic size of ~ 100 µm) radiation sources disclosed in the present invention.

In general, the invention is applicable to a number of EUV light sources based on laser produced plasma or laser-initiated discharge produced plasma.

In one aspect, the invention relates to a low-debris LPP EUV light source with fast rotating liquid metal target made of "heavy lithium", i.e. of the target material in any of the disclosed configurations.

In accordance with this, the present invention may provide the possibility of creating low-debris high-brightness monochromatic radiation sources at 13.5 nm with a wide range of applications.

The features of the aspect and embodiments disclosed herein may be combined with each other unless noted to the contrary.

The advantages and features of the present invention will become more apparent from the following non-limiting description of exemplary embodiments thereof, given by way of example with reference to the accompanying drawings.

### BRIEF DESCRIPTION OF THE DRAWINGS

An exemplary implementation of the invention is illustrated by the drawings, in which:
Fig. 1 is a schematic diagram of a high brightness LPP EUV light source with fast rotating target in accordance with an embodiment,
Fig. 2 is a simplified schematic of a high brightness LPP EUV light source in accordance with the embodiment,
Fig. 3A and Fig. 3B - show diagrams that illustrate the results of calculating the spatial distribution of droplet ejection from the interaction zone for target materials of Li and composition with atomic fractions of Li (80%) and Ag (20%),
Fig. 4A and Fig. 4B show SEM images, demonstrating achievement of debris mitigation effect by replacing the Li target material with the composition 80%Li+20%A in the high brightness LPP EUV light source,
Fig. 5A and Fig. 5B show spectra of the EUV radiation source for the target material of Li and the composition of 80%Li+20%Ag,
Fig. 6 shows a spectral reflectivity curve of the Mo/Si mirror used as a reflective filter,
Fig. 7A and Fig. 7B show radiation spectra after reflection from a Mo/Si mirror for a target material of Li and a composition of 80%Li+20%Ag,
Fig. 8A, Fig. 8B, Fig. 8C and Fig. 8D show simplified schematics of the EUV light source in accordance with the embodiments of the invention.

In the drawings, the matching elements of the device have the same reference numbers.

These drawings do not cover and, moreover, do not limit the entire scope of the options for implementing this technical solution, but represent only illustrative material of a particular case of its implementation.

### DETAILED DESCRIPTION OF THE PREFERRED EMBODIMENTS

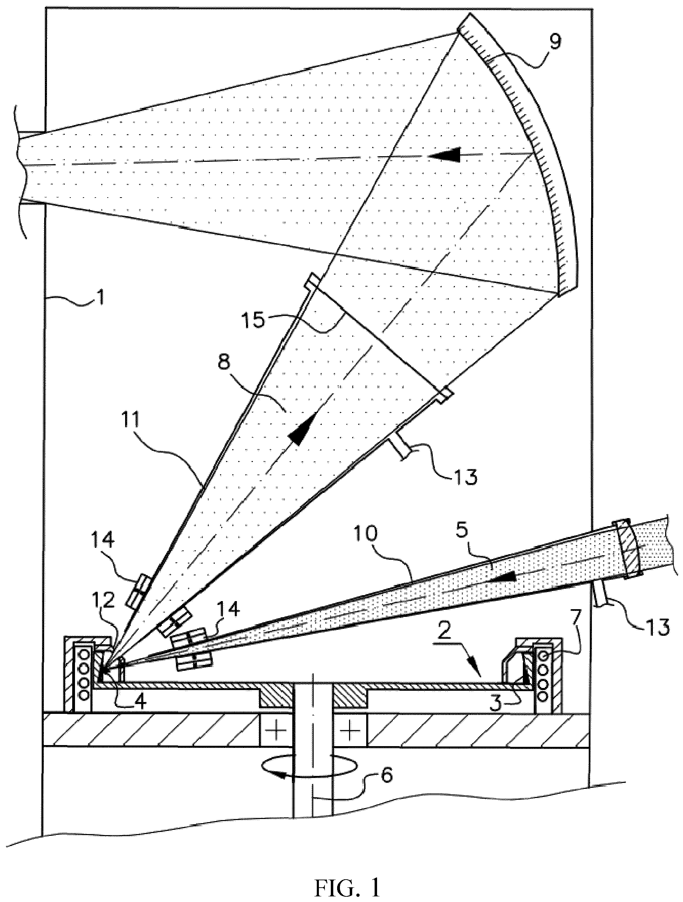

According to an exemplary embodiment of the invention illustrated in Fig. 1, the high-brightness source of short-wavelength radiation contains a vacuum chamber 1 with a rotating target assembly 2, which supplies a target 3 to the interaction zone 4 where the target 3 interacts with a focused laser beam 5. A part of the rotating target assembly 2 is made in the form of a disk fixed to the rotation shaft. Said disk has a peripheral portion in the form of an annular barrier with the annular groove facing the rotation axis 6. The target 3 is a layer of molten metal formed by centrifugal force on the surface of the annular groove of the rotating target assembly 2. The target 3 employs the target material in any of the configurations disclosed herein.

Material of target is melted and maintained in a given optimal temperature range using a heating system 7.

The annular groove configuration prevents material of the target 3 from being ejected in the radial direction and in both directions along the rotation axis 6, if the target material volume does not exceed the groove's volume.

In the interaction zone 4, under the action of a focused laser beam 5, a pulsed high-temperature plasma of the target material is generated. The plasma generates radiation in the EUV spectral range. Generated EUV radiation leaves the interaction zone 4 in the form of a divergent beam of EUV radiation 8.

In the embodiment of the invention, the beam of EUV radiation is directed at the optical collector 9 in the form of a Mo/Si mirror with a maximum reflection at a wavelength of 13.5 nm. In other cases, a collector based on glazing incidence mirrors or optical elements in the form of Fresnel zone plates can be used.

On the paths of the focused laser beam 5 and the beam of EUV radiation 8, there are means for debris mitigation, provided by one or more techniques comprising:
casings 10, 11 surrounding the beams 5, 8 of laser and EUV radiation;
protective gas flows directed through gas inlets 13 in the casings 10, 11 to mitigate the vapor fraction of debris particles in the path of laser and EUV radiation beams;
debris shield 12, separated from the rotating target assembly 2 by slit gaps, having only two small holes (for the input of a focused laser beam and for the output of a beam of EUV radiation), through which debris particles can leave the target assembly;
foil trap (not shown), highly transparent for plasma radiation which is essentially a system of plates oriented in radial directions with respect to the plasma, providing a sufficiently effective trapping of neutral atoms and clusters of the target material;
a magnetic field preferably generated by permanent magnets to mitigate the charged fraction of debris particles; and
a preferably replaceable membrane 15 essentially transparent for short-wavelength radiation and impermeable for debris and gas.

The membrane installed on the path of the EUV radiation beam is preferably made of a material belonging to a group which includes carbon nanotubes (CNT), Ti, Al, Si, ZrSi, BN.

Similar means for debris mitigation are placed in the propagation path of the focused laser beam 5.

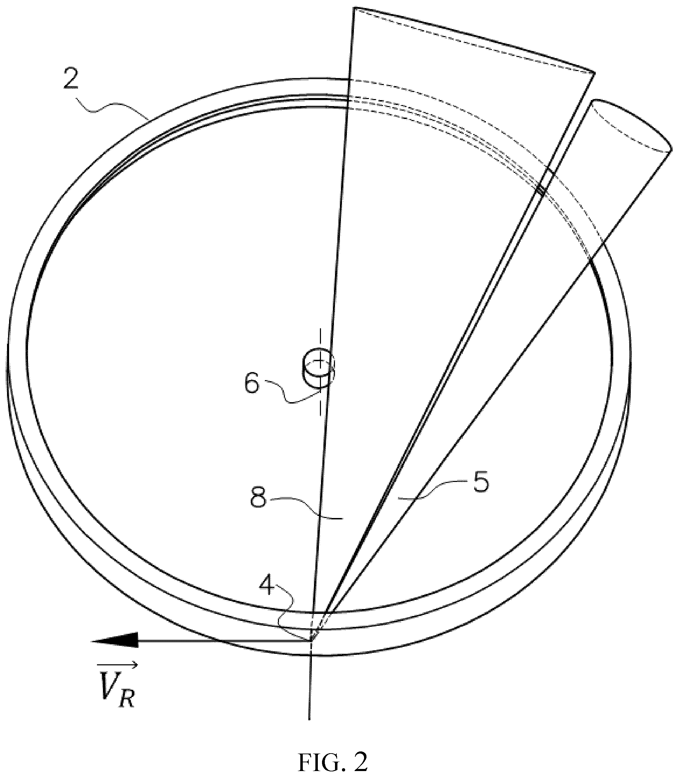

Fig. 2 shows a simplified diagram of the above-described EUV light source, for which computational modeling of spatial distribution of debris ejection from the interaction zone 4 performed using the RZLINE code which is created for applications in the field of radiation hydrodynamics of dense hot plasma. The code uses mathematical models based on years of experimental and theoretical work as, for example, it is known from the publication K. Koshelev, V. Ivanov, V. Medvedev, et al., "Return-to-zero line code modeling of distributed tin targets for laser-produced plasma sources of extreme ultraviolet radiation", Journal of Micro / Nanolithography, MEMS, and MOEMS Vol. 11, Issue 2 (May 2012). The code allows modeling the interaction of laser radiation with gases, liquids and solid surfaces with subsequent generation of plasma, as well as interaction with the plasma itself.

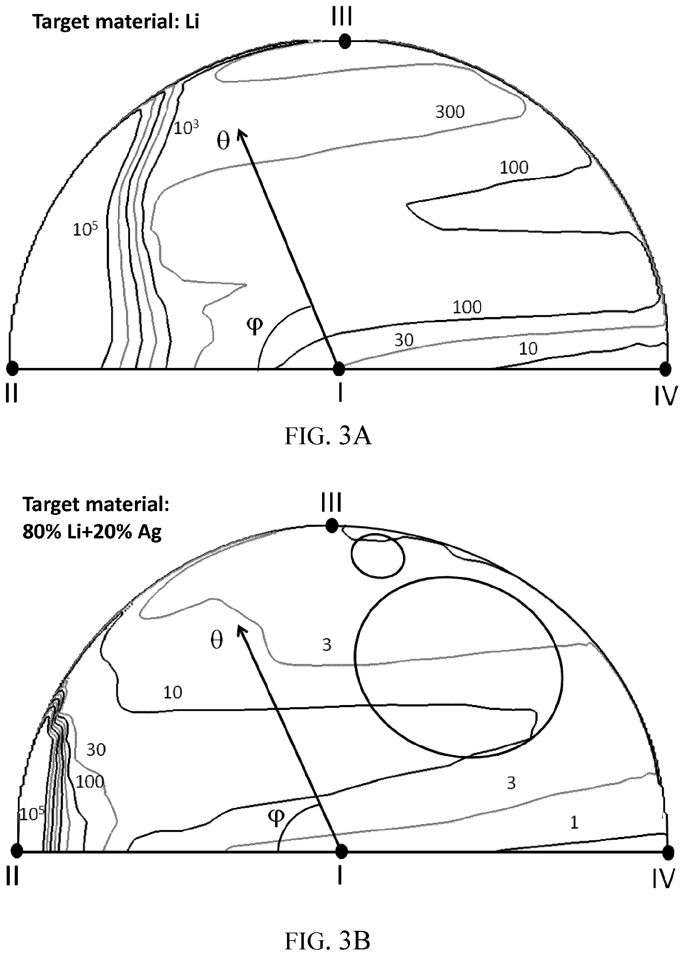

In Fig. 3 for Li and Li/Ag target materials are shown maps of the spatial distribution of ejection rates of debris particles (particles of all fractions of all velocities are taken into account) in experimental coordinates, in which θ- is the angle to rotation axis, φ- is the azimuthal angle lying in the plane of the figure. The origin of coordinates is in the interaction zone. Typical directions in the interaction zone are as follows:
I - parallel to the rotation axis: θ = 0, φ - any,
II - along target velocity: θ = 90°, φ= 0°,
III - normal to the target surface: θ = 90°, φ = 90°,
IV - against target velocity: θ = 90°, φ = 180°.

Spatial distributions of the debris ejection rate shown in Fig. 3 were calculated in nm/(month·W) as a specific growth rate of the film thickness of deposited debris particles on a surface of the exposed sample located at a distance of 40 cm from the interaction zone per unit of laser power with the EUV source operating 24/7.

This distribution was obtained for typical values of the light source parameters: the laser radiation wavelength is ~ 1-2 µm, the laser pulse energy is several mJ at pulse duration of several ns, the focal spot diameter is several tens of µm and the target linear velocity is 200 m/s. Apart from the fast target rotation no other debris mitigation techniques were used.

As illustrated in Fig. 3, the mass of debris particles is mainly concentrated in the sector along the direction of the target velocity limited by the «azimuth angles» φ of 0°-80° and by the «polar angles» θ of 0°-90°. Maximum debris ejection rate along the direction of the target rotation is 10⁷ nm/(month·W).

In Fig. 3 ovals are used to indicate the spatial regions selected in accordance with embodiments with minimal levels of debris ejection rates, in which the cones of laser and EUV radiation beams are located.

Calculation results for target materials from Li, Fig. 3A, and compositions of 80%Li and 20%Ag (in atomic fractions), Fig. 3B, show the following. The increase in the density of the target material (in this case by 4.7 times compared to lithium) makes it possible to sharply (by more than an order of magnitude) reduce the ejection rate of debris particles into the spatial regions of laser and EUV beams.

The achievement of this positive effect of the invention is confirmed experimentally using the source schematically shown in Fig. 1, in which the test sample was placed instead of the membrane 15.

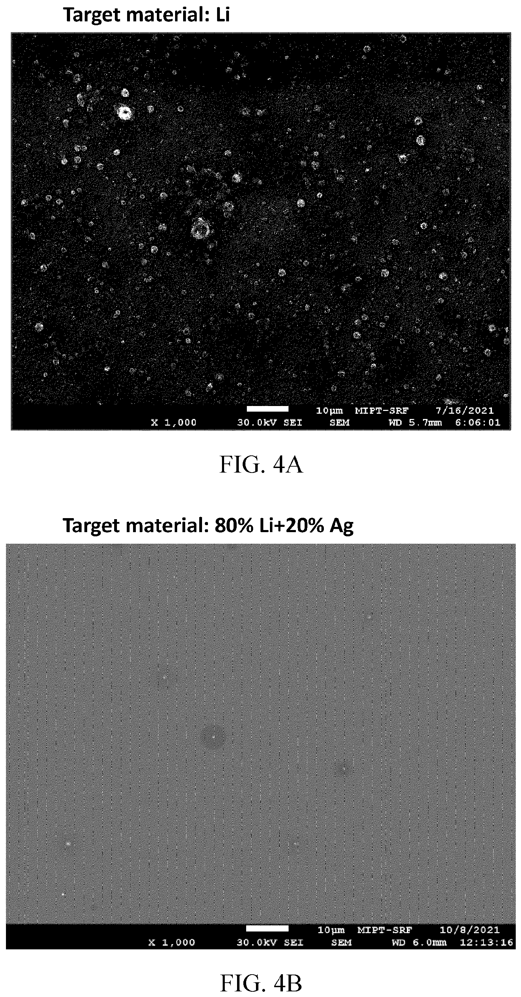

Fig. 4 shows scanning electron microscope (SEM) images of the witness samples obtained for target materials from Li, Fig. 4A, and compositions of 80%Li and 20%Ag, Fig. 4B. Frame size of SEM images is 125 µm. Tests were carried out under the following conditions:
linear velocity of the target is 150 m/s, centrifugal acceleration is 23000 g,
laser beam energy is 3.3 mJ/pulse on the target, focal spot size- 120 µm at 1/e² intensity level,
pulse repetition rate - 25 kHz,
exposure time of the witness samples is 2.5 hours (Fig. 4A) and 10 hours (Fig. 4B).

It can be seen that an increase in the density of the target material in accordance with the invention leads to a sharp debris mitigation effect.

Based on the tests performed, it was shown that relatively large droplets larger than 300 nm, which can penetrate through the CNT membrane, are completely suppressed. Thus, the replacement of the test sample with a replaceable membrane, in particular made of carbon nanotubes, allows for ultra-high purity of a high-brightness monochromatic radiation source at 13.5 nm, made in accordance with the present invention.

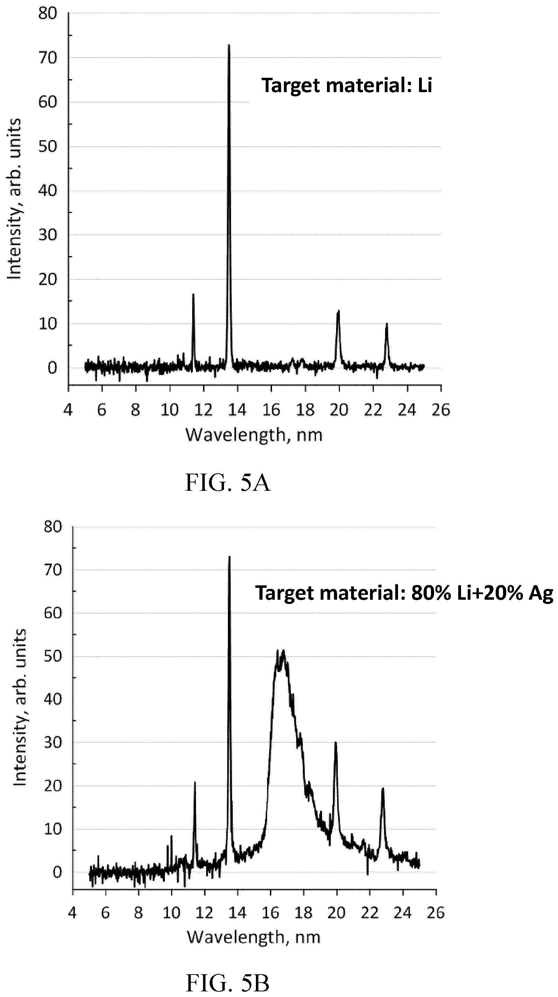

Fig. 5A and Fig. 5B show spectra of the EUV light source for the target material of Li and the composition of 80%Li+20%Ag, respectively. Spectra shown in Fig. 5 are measured using the EUV light source schematically shown in Fig. 1 for radiation coming directly from the plasma (without reflection from the mirror 9 and without the use of a membrane 15). It can be seen that the emission intensity of Li²⁺line at 13.5 nm practically does not change when replacing the target material from Li with a composition of 80%Li+20%Ag. At the same time, due to the presence of Ag ions in the plasma, an emitting band with a peak at a wavelength of 17 nm appears which does not overlap with the emission line of Li²⁺ at 13.5 nm, which can be easily filtered out, for example, using a Mo/Si mirror 9, Fig. 1.

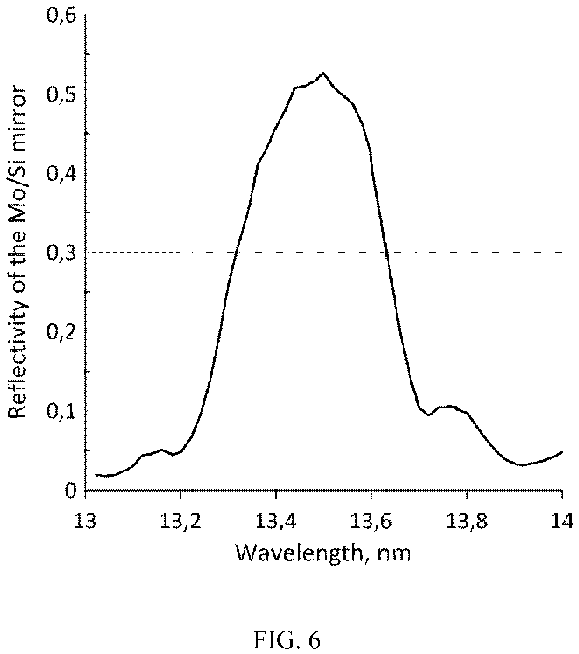

Fig. 6 shows the spectral reflectivity curve of the Mo/Si mirror with a reflection band into which the radiation from the Ag plasma does not fall. This determines the possibility of using a multilayer Mo/Si mirror as a reflective filter in accordance with the present invention, not limited only to this option. Similarly, other types of filters can be used, for example, made from foils containing zirconium or beryllium.

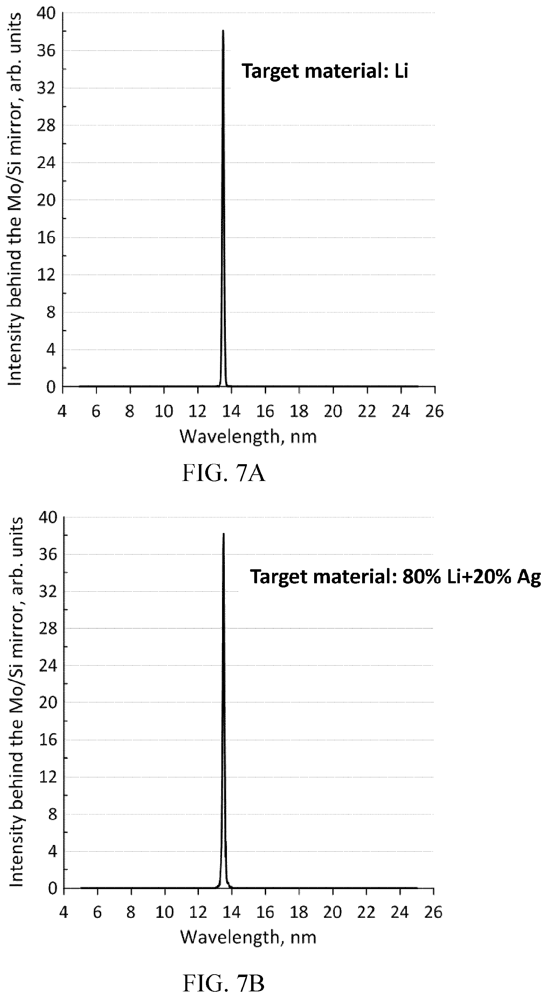

As can be seen from Fig. 7A and Fig. 7B, spectra of the EUV light source after reflection from the Mo/Si mirror practically coincide for the target materials of Li and the composition of 80%Li+20%Ag.

The radiation behind the multilayer mirror is monochromatic with a bandwidth of λ/Δλ≥1300. This value was estimated from measured bandwidths (a spectrometer with a spectral resolution λ/Δλ up to 500 was used) of spectral lines Li²⁺ (1s-4p) at 10.8nm, Li²⁺ (1s-3p) at 11.39nm and Li²⁺ (1s-2p) at 13.5nm, Fig. 5A.

In the EUV light source, the maximum conversion efficiency CE_{13.5} of laser radiation energy into in band EUV radiation (13.5±0.135 nm) in 2π sr spatial angle was 2% for both of these Li-based materials of target.

In general, there is a set of parameters, which includes the size of the laser spot, the energy and duration of the laser pulse, which provide, along with a high CE, a minimum amount of debris.

The method for generating radiation using a EUV light source, schematically shown in Fig. 1, Fig. 2 and Fig. 3 is implemented as described below.

Under the action of centrifugal force, the target is created in the form of a layer of molten metal on the surface of an annular groove of a rotating target assembly 2, the surface facing the rotation axis 6. The target 3 is irradiated by a pulsed focused laser beam 5 resulting in the formation of plasma in the interaction zone 4. The output beam of EUV radiation 8 is generated passing into an optical collector 9 through the means for debris mitigation 11, 12, 13, 14, 15.

The rotation of the target is carried out with a high linear velocity, not less than 100 m/s. In accordance with the embodiments disclosed herein, a target material containing a lithium composition with at least one further element is used, which makes it possible to increase multiple times, e.g. more than three times, the density of the material of target compared to the density of Li and thereby dramatically reduce the ejection rate of droplet fraction of debris particles. The droplet fraction of debris particles, due to the fast target rotation, acquires a significant tangential component of the velocity comparable to the velocity of droplet flyout, which, in accordance with the invention, is sharply reduced by increasing the density of the Li-containing target material. As a result, the velocity vector of the droplet fraction of debris particles is directed away from the beams 5, 8 of laser and EUV radiation, the propagation paths for which are chosen in spatial regions with minimal levels of debris ejection rate.

Ag or Au is preferably chosen as a further element of the target material, which makes it possible, even with its small, e.g. 20%, atomic fraction, to increase the density of the target material many times (about 5 and 8 times, respectively) compared to the density of Li. In preferred embodiments of the invention, the material of target is a eutectic alloy in which the atomic fraction of Li is in the range from 60% to 90%, which ensures the uniformity of the target material and its relatively low melting point.

Bi, Ba, Sr can also be used as a further element of the target material.

In the EUV radiation beam 8, spectral filtering of narrowband line emission of Li²⁺ at 13.5 nm is carried out, for example, using a Mo/Si mirror 9, which plays the role of a reflective filter. Foils, in particular, containing zirconium or beryllium, can also be used as a filter.

When generating EUV radiation, means for debris mitigation 11, 12, 13, 14, 15 are used, comprising protective gas flow, magnets, a foil trap, a membrane 15 largely transparent at 13.5 nm, and a debris shield 12 installed outside the regions of propagation of laser and EUV radiation beams 5, 8.

When using fast target rotation with high target velocity of more than 100 m/s and centrifugal acceleration of at least 10000 g, the surface of the target 4 is round-cylindrical. As a result, a stable shape of the target surface 3 in the interaction zone 4 is ensured and long-term stability of the EUV radiation source is achieved due to continuous circulation and updating of the target material in the interaction zone and restoration of the shape of the target surface after the next laser pulses.

In general, the target material made in accordance with the present invention is applicable to a wide range of EUV light sources of various types known from the prior art, both based on laser produced plasma and discharge produced plasma.

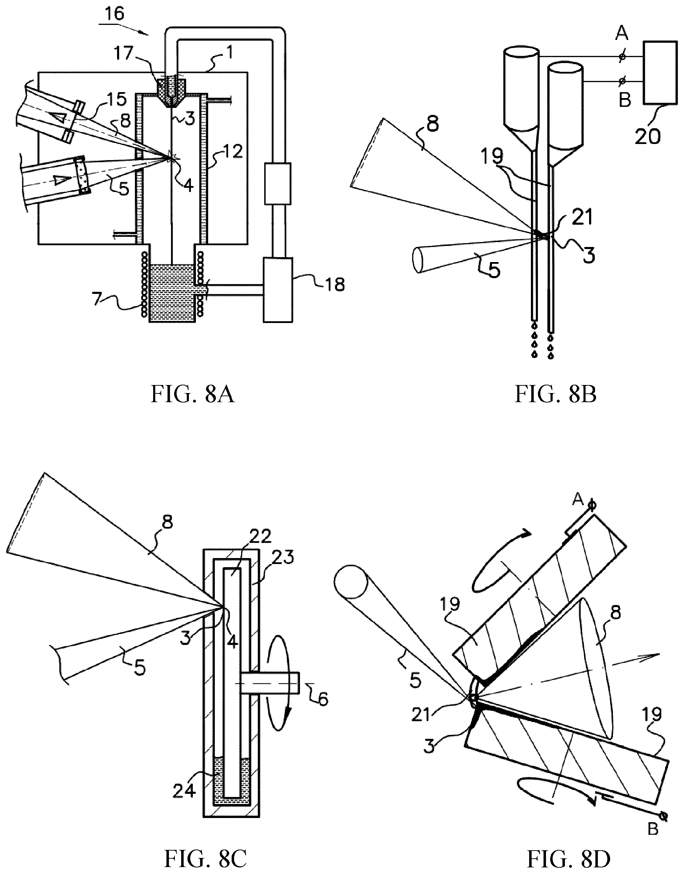

For example, Fig. 8 shows embodiments of the EUV light sources using a target material made in accordance with embodiments of the present invention.

In Fig. 8A the LPP EUV light source has the target 3 in the form of liquid metal jet circulating at high speed through the interaction zone 4 along a closed loop 16 with a nozzle 17 and a high-pressure pump 18 for transferring molten target material. A debris shield 12 with a temperature exceeding the melting point of target material is installed around the jet. The jet can be continuous or consist of individual target droplets following each other at high speed. Other parts of the device in this embodiment are the same as in the above embodiments (Fig. 1, Fig. 2), have the same item numbers in Fig. 8, and their detailed description is omitted here and below.

In another embodiment, shown in Fig. 8B, two high-speed liquid metal jets are used as electrodes 19 connected to a pulsed power source 20 to produce a laser-initiated discharge plasma 21 in vapors of the target material of target 3.

In another embodiment, shown in Fig. 8C, the LPP EUV light source is shown in which the target material of the target 3 is delivered into interaction zone 4 by a fast rotating disk 22 with a casing 23, in which there are holes for the input of laser beam 5, and exit of EUV radiation beam 8. Outside the interaction zone 4, the disk 22 is wetted with the molten target material 24.

Similarly, in the embodiment illustrated by Fig. 8D, two fast rotating disks 22 wetted with molten target material are used as electrodes 19 to produce a laser-initiated discharge produced plasma 21 in vapors of the target material of target 3.

Thus, the present invention may make it possible to create monochromatic EUV light sources at a wavelength of 13.5 nm characterized by high spectral brightness and average power, long service life and ease of use.

### INDUSTRIAL APPLICATION

The proposed devices are intended for a number of applications, including microscopy, materials science, X-ray diagnostics of materials, biomedical and medical diagnostics, inspection of nano- and microstructures and lithography, including actinic control of lithographic EUV masks.

## Claims

1. A plasma source for production of EUV radiation, wherein the plasma source is configured to produce a plasma as either a laser produced plasma or a laser-initiated discharge produced plasma, the plasma source comprising a target material to produce the plasma, wherein
the target material comprises a lithium, Li,-based composition with at least one further element, **characterised in that**
the composition is an alloy and wherein the at least one further element is selected from the group consisting of Ag, Au, Bi, Ba, Sr, wherein the type and amount of the at least one further element in the composition is configured to increase the density of the target material by more than three times compared to the density of Li.

2. The plasma source according to claim 1, wherein the composition comprises an eutectic alloy.

3. The plasma source according to any of the preceding claims, wherein the atomic percentage of Li in the target material is in the range from 60% to 90%.

4. The plasma source according to any of the preceding claims, wherein the atomic percentage of the at least one further element in the target material is in the range from 10% to 40%, preferably from 15% to 30%, wherein preferably, the sum of the atomic percentage of Li and of the at least one further element in the target material amount to about 100%.

5. A laser produced plasma EUV source comprising: a plasma source according to any of claims 1-4, a vacuum chamber (1), a rotating target assembly (2) configured to supply a target (3) into an interaction zone (4) with the laser beam (5) focused onto the target (3), wherein the target (3) is a layer of molten target material on a surface of an annular groove implemented in the rotating target assembly (2) with a target surface facing a rotation axis (6) of the rotating target assembly (2), wherein the laser produced plasma EUV source is configured to pass an EUV radiation beam (8) exiting the interaction zone (4), and means for debris mitigation (10, 11, 12, 13, 14, 15), wherein a linear velocity of the target is preferably not less than 100 m/s.

6. The laser produced plasma EUV source according to claim 5, wherein a spectral purity filter is installed in the way of the EUV radiation beam, wherein the spectral purity filter is preferably selected from the group comprising: a reflective filter in the form of a multilayer Mo/Si mirror (9), foil containing zirconium or beryllium.

7. The laser produced plasma EUV source according to any of claims 5 to 6, wherein the means of debris mitigation is provided by one or more debris mitigation techniques comprising: protective gas flow, a magnetic mitigation, a foil trap, a debris shield, a membrane mostly transparent for EUV radiation.

8. A method for generating extreme ultraviolet, EUV, radiation, comprising:
generating a radiation beam having a wavelength in an EUV range by means of a plasma source according to any of claims 1-4,

9. The method according to claim 8, further comprising:
forming under an action of a centrifugal force a target (3) as a layer of the target material in a molten state on a surface of an annular groove that is implemented in a rotating target assembly (2) with a target surface facing a rotation axis (6) of the rotating target assembly (2);
irradiating the target (3) by a focused laser beam (5);
generating a laser produced plasma in an interaction zone (4); and
outputting an EUV radiation beam (8) through means for debris mitigation (10, 11, 12, 13, 14, 15), wherein the target (3) is preferably rotated at a high linear velocity, not less than 100 m/s.

10. The method according to claim 9, wherein the centrifugal acceleration of the target (3) is at least 10000 g, where g is the acceleration of gravity.

11. The method according to claim 9 or 10, wherein a spatial distribution of a debris ejection rate from the interaction zone (4) is calculated and directions of a passage of both focused laser beam (5) and the EUV radiation beam (8) are selected in spatial regions with minimal debris ejection rates.

12. The method according to any of claims 9-11, wherein the debris mitigation is provided by one or more debris mitigation techniques comprising: protective gas flow (13), a magnetic mitigation (14), a foil trap, a debris shield (12), a membrane mostly transparent for EUV radiation (15), with a transparency of more than 60%.

13. The method according to any of claims 9-12, 4, wherein in the EUV radiation beam (8) a spectral filtering of narrow-band radiation is provided at a transition of ionized Li²⁺ with a wavelength of 13.5 nm.

## Patentansprüche

1. Plasmaquelle zur Erzeugung von EUV-Strahlung, wobei die Plasmaquelle so konfiguriert ist, dass sie ein Plasma entweder als lasererzeugtes Plasma oder als laserinitiiertes Entladungsplasma erzeugt, und die Plasmaquelle ein Targetmaterial zur Plasmaerzeugung umfasst, wobei
das Targetmaterial eine auf Lithium, Li-basierende Zusammensetzung mit mindestens einem weiteren Element umfasst, **dadurch gekennzeichnet, dass** die Zusammensetzung eine Legierung ist und das mindestens ein weiteres Element aus der Gruppe bestehend aus Ag, Au, Bi, Ba, Sr ausgewählt ist, wobei Art und Menge des mindestens eines weiteren Elements in der Zusammensetzung so gewählt sind, dass die Dichte des Targetmaterials im Vergleich zur Dichte von Li um mehr als das Dreifache erhöht wird.

2. Plasmaquelle nach Anspruch 1, wobei die Zusammensetzung eine eutektische Legierung umfasst.

3. Plasmaquelle nach einem der vorhergehenden Ansprüche, wobei der Atomanteil von Li im Targetmaterial im Bereich von 60% bis 90% liegt.

4. Plasmaquelle nach einem der vorhergehenden Ansprüche, wobei der Atomanteil des mindestens eines weiteren Elements im Targetmaterial im Bereich von 10% bis 40%, vorzugsweise von 15% bis 30% liegt, wobei vorzugsweise die Summe der Atomanteile von Li und des mindestens eines weiteren Elements im Targetmaterial etwa 100% beträgt.

5. Lasererzeugte Plasma-EUV-Quelle, umfassend: eine Plasmaquelle gemäß einem der Ansprüche 1-4, eine Vakuumkammer (1), eine rotierende Targeteinheit (2), die so konfiguriert ist, dass sie ein Target (3) in eine Wechselwirkungszone (4) mit dem Laserstrahl (5) liefert, der auf das Target (3) fokussiert ist, wobei das Target (3) eine Schicht aus geschmolzenem Targetmaterial auf einer Oberfläche einer ringförmigen Nut ist, die in der rotierenden Targeteinheit (2) ausgeführt ist und deren Targetoberfläche zur Rotationsachse (6) in der rotierenden Targeteinheit (2) zeigt, wobei die lasererzeugte Plasma-EUV-Quelle so konfiguriert ist, dass sie einen EUV-Strahl (8), der aus der Wechselwirkungszone (4) austritt, durch Mittel zur Verunreinigungsminderung (10, 11, 12, 13, 14, 15) leitet,
wobei die lineare Geschwindigkeit des Targets vorzugsweise nicht weniger als 100 m/s beträgt.

6. Lasererzeugte Plasma-EUV-Quelle nach Anspruch 5, wobei ein Filter zur spektralen Reinheit im Strahlengang des EUV-Strahls installiert ist, wobei der Filter vorzugsweise aus der Gruppe ausgewählt ist, bestehend aus: einem reflektierenden Filter in Form eines mehrschichtigen Mo/Si-Spiegels (9), Folie mit Zirkonium oder Beryllium.

7. Lasererzeugte Plasma-EUV-Quelle nach einem der Ansprüche 5-6, wobei die Mittel zur Verunreinigungsminderung durch eine oder mehrere Techniken bereitgestellt werden, umfassend: Schutzgasstrom, magnetische Minderung, Folienfalle, Verunreinigungsschild, Membran, die größtenteils transparent für EUV-Strahlung ist.

8. Verfahren zur Erzeugung von extrem ultravioletter, EUV, Strahlung, umfassend:
das Erzeugen eines Strahlenbündels mit einer Wellenlänge im EUV-Bereich mittels einer Plasmaquelle gemäß einem der Ansprüche 1-4.

9. Verfahren nach Anspruch 8, weiterhin umfassend:
Bilden eines Targets (3) als Schicht des Targetmaterials im geschmolzenen Zustand auf einer Oberfläche einer ringförmigen Nut unter Einwirkung einer Zentrifugalkraft, wobei die Nut in einer rotierenden Targeteinheit (2) ausgeführt ist, wobei eine Targetoberfläche zur Rotationsachse (6) der rotierenden Targeteinheit (2) zeigt;
das Bestrahlen des Targets (3) mit einem fokussierten Laserstrahl (5);
das Erzeugen eines lasererzeugten Plasmas in einer Wechselwirkungszone (4); und
Ausgeben eines EUV-Strahls (8) durch Mittel zur Verunreinigungsminderung (10, 11, 12, 13, 14, 15), wobei das Target (3) vorzugsweise mit einer hohen linearen Geschwindigkeit von nicht weniger als 100 m/s rotiert wird.

10. Verfahren nach Anspruch 9, wobei die Zentrifugalbeschleunigung des Targets (3) mindestens 10.000 g beträgt, wobei g die Erdbeschleunigung ist.

11. Verfahren nach Anspruch 9 oder 10, wobei eine räumliche Verteilung der Verunreinigungsausstoßrate aus der Wechselwirkungszone (4) berechnet wird und die Richtungen des Durchgangs sowohl des fokussierten Laserstrahls (5) als auch des EUV-Strahls (8) in räumlichen Bereichen mit minimalen Verunreinigungsausstoßraten gewählt werden.

12. Verfahren nach einem der Ansprüche 9-11, wobei die Verunreinigungsminderung durch eine oder mehrere Techniken bereitgestellt wird, umfassend: Schutzgasstrom (13), magnetische Minderung (14), Folienfalle, Verunreinigungsschild (12), Membran, die größtenteils transparent für EUV-Strahlung (15) ist, mit einer Transparenz von mehr als 60%.

13. Verfahren nach einem der Ansprüche 9-12, wobei im EUV-Strahl (8) eine spektrale Filterung von schmalbandiger Strahlung bei einem Übergang von ionisiertem Li²⁺ mit einer Wellenlänge von 13,5 nm bereitgestellt wird.

## Revendications

1. Source de plasma pour la production d'un rayonnement d'UVE, dans laquelle la source de plasma est configurée pour produire un plasma soit en tant que plasma produit par laser, soit en tant que plasma produit par décharge initiée par laser, la source de plasma comprenant un matériau cible pour produire le plasma, dans laquelle :
le matériau cible comprend une composition à base de lithium, Li, avec au moins un autre élément, **caractérisée en ce que** la composition est un alliage, et dans laquelle l'au moins un autre élément est sélectionné parmi le groupe constitué par Ag, Au, Bi, Ba et Sr ; et dans laquelle :
le type et la quantité de l'au moins un autre élément dans la composition sont configurés pour augmenter la densité du matériau cible d'un facteur de plus de trois par comparaison avec la densité du Li.

2. Source de plasma selon la revendication 1, dans laquelle la composition comprend un alliage eutectique.

3. Source de plasma selon l'une quelconque des revendications précédentes, dans laquelle le pourcentage atomique du Li dans le matériau cible s'inscrit à l'intérieur de la plage de 60 % à 90 %.

4. Source de plasma selon l'une quelconque des revendications précédentes, dans laquelle le pourcentage atomique de l'au moins un autre élément dans le matériau cible s'inscrit à l'intérieur de la plage de 10 % à 40 %, de préférence de 15 % à 30 %, et dans laquelle, de préférence, la somme du pourcentage atomique du Li et de l'au moins un autre élément dans le matériau cible est égale à environ 100 %.

5. Source d'UVE par plasma produit par laser comprenant :
une source de plasma selon l'une quelconque des revendications 1 à 4, une chambre à vide (1) et un assemblage de cible rotative (2) configuré pour alimenter une cible (3) à l'intérieur d'une zone d'interaction (4), le faisceau laser (5) étant focalisé sur la cible (3) ; dans laquelle :
la cible (3) est une couche de matériau cible fondu sur une surface d'une gorge annulaire mise en œuvre dans l'assemblage de cible rotative (2), une surface de la cible faisant face à un axe de rotation (6) de l'assemblage de cible rotative (2) ; dans laquelle :
la source d'UVE par plasma produit par laser est configurée pour faire passer un faisceau de rayonnement d'UVE (8) qui sort de la zone d'interaction (4) ; et
un moyen pour réduire les débris (10, 11, 12, 13, 14, 15) ; et dans laquelle : une vitesse linéaire de la cible est de préférence non inférieure à 100 m/s.

6. Source d'UVE par plasma produit par laser selon la revendication 5, dans laquelle :
un filtre de pureté spectrale est installé dans le chemin du faisceau de rayonnement d'UVE ; et dans laquelle :
le filtre de pureté spectrale est de préférence sélectionné parmi le groupe comprenant : un filtre réfléchissant sous la forme d'un miroir en Mo/Si à multiples couches (9) et une feuille contenant du zirconium ou du béryllium.

7. Source d'UVE par plasma produit par laser selon l'une quelconque des revendications 5 et 6, dans laquelle le moyen de réduction de débris est constitué au moyen d'une ou de plusieurs techniques de réduction de débris comprenant : un flux de gaz de protection, une réduction magnétique, un piège à feuilles, un dispositif de protection contre les débris et une membrane presque entièrement transparente pour le rayonnement d'UVE.

8. Procédé pour générer un rayonnement des ultraviolets extrêmes, UVE, comprenant :
la génération d'un faisceau de rayonnement présentant une longueur d'onde dans une plage des UVE au moyen d'une source de plasma selon l'une quelconque des revendications 1 à 4.

9. Procédé selon la revendication 8, comprenant en outre :
la formation, sous une action d'une force centrifuge, d'une cible (3) en tant que couche du matériau cible dans un état fondu sur une surface d'une gorge annulaire qui est mise en œuvre au sein d'un assemblage de cible rotative (2), une surface de la cible faisant face à un axe de rotation (6) de l'assemblage de cible rotative (2) ;
l'irradiation de la cible (3) par un faisceau laser focalisé (5) ;
la génération d'un plasma produit par laser dans une zone d'interaction (4) ; et
l'émission en sortie d'un faisceau de rayonnement d'UVE (8) au travers d'un moyen pour la réduction des débris (10, 11, 12, 13, 14, 15),
dans lequel la cible (3) est de préférence entraînée en rotation à une vitesse linéaire élevée, non inférieure à 100 m/s.

10. Procédé selon la revendication 9, dans lequel l'accélération centrifuge de la cible (3) est d'au moins 10000 g, dans lequel g est l'accélération de la gravité.

11. Procédé selon la revendication 9 ou 10, dans lequel une distribution spatiale d'un flux d'éjection de débris en provenance de la zone d'interaction (4) est calculée et des directions d'un passage à la fois du faisceau laser focalisé (5) et du faisceau de rayonnement d'UVE (8) sont sélectionnées dans des régions spatiales présentant des flux d'éjection de débris minimums.

12. Procédé selon l'une quelconque des revendications 9 à 11, dans lequel la réduction des débris est assurée au moyen d'une ou de plusieurs techniques de réduction de débris comprenant : un flux de gaz de protection (13), une réduction magnétique (14), un piège à feuilles, un dispositif de protection contre les débris (12) et une membrane presque entièrement transparente pour le rayonnement d'UVE (15), présentant une transparence supérieure à 60 %.

13. Procédé selon l'une quelconque des revendications 9 à 12, dans lequel, au sein du faisceau de rayonnement d'UVE (8), un filtrage spectral de rayonnement en bande étroite est assuré au niveau d'une transition du Li²⁺ ionisé selon une longueur d'onde de 13,5 nm.
